# EUROPEAN PATENT APPLICATION

(11) **EP 4 425 564 A1**
(43) Date of publication of application: **04.09.2024**
(21) Application number: 24160430.5
(22) Date of filing: 29.02.2024
(51) Int. Cl.: H01L 29/06, H01L 29/78

(54) **IMPACT-RESISTANT SUPER JUNCTION DEVICE AND PREPARING METHOD THEREOF**

(30) Priority: 03.03.2023 CN 202310195393
(71) Applicant: Chongqing Alpha and Omega Semiconductor Limited, Chongqing 400700 (CN)
(72) Inventor: QIN, Xiao Feng, Chongqing 400700 (CN); SHI, Liang, Chongqing 400700 (CN); HU, Wei, Chongqing 400700 (CN)
(74) Representative: Herrero & Asociados, S.L.

(57) **Abstract**

An impact-resistant super junction device and a preparing method thereof are provided. The impact-resistant super junction device includes a silicon substrate (1), a first epitaxial layer (2), a second epitaxial layer (3), at least one voltage-resistant layer (4,5), a gate oxide layer (6), gates (7), an interlayer dielectric (10), metal through holes (11), a circuit link layer (12), and at least one passivation layer (13) that are sequentially disposed from bottom to top. The at least one voltage-resistant layer includes a first columnar region and a second columnar region. Body regions and sources are disposed between the at least one voltage-resistant layer and the gate oxide layer. The metal through holes are uniformly distributed in the interlayer dielectric. The preparing method includes preparing epitaxial layers, preparing the at least one voltage-resistant layer; preparing a VDMOS structure, and preparing a circuit link layer and the at least one passivation layer. The layout of the p- (dashed) and n-regions (white) of the super-junction is optimised to achieve charge balance.

## Description

### TECHNICAL FIELD

The present disclosure relates to a technical field of layout for improving impact resistance of super junction devices, and in particular to an impact-resistant super junction device and a preparing method thereof.

### BACKGROUND

Super junction devices are semiconductor components that utilize a repeated structure of vertical P-type doped columns and N-type doped columns to realize horizontal electric field component and thereby improving vertical voltage resistance. Compared with conventional vertical double-diffused metal-oxide semiconductor (VDMOS) devices, the super junction devices adopt higher concentrations of N-type ion doping and P-type ion doping, which greatly reduce a voltage on a conductive channel. Therefore, the super junction devices have strong overcurrent capability, high power density, fast switching speed, and low output loss.

However, the super junction devices currently on the market require deep P-type columns and deep N-type columns to realize voltage resistance. In an actual production process, a certain process tolerance is required for processing the deep P-type columns and the deep N-type columns, so specific design methods are needed to realize good impact resistance of the super junction devices within a parameter calibration range of the super junction devices.

### SUMMARY

In order to solve defects in the prior art, a first purpose of the present disclosure is to provide an impact-resistant super junction device.

The impact-resistant super junction device comprises a silicon substrate, a first epitaxial layer, a second epitaxial layer, at least one voltage-resistant layer, a gate oxide layer, gates, an interlayer dielectric, metal through holes, a circuit link layer, and at least one passivation layer.

The silicon substrate, the first epitaxial layer, the second epitaxial layer, the at least one voltage-resistant layer, the gate oxide layer, the gates, the interlayer dielectric, the metal through holes, the circuit link layer, and the at least one passivation layer are sequentially disposed from bottom to top. The at least one voltage-resistant layer comprises a first columnar region and a second columnar region. The second columnar region is of a first polarity, and the first columnar region is of a second polarity. The first polarity is opposite to the second polarity. Body regions and sources are disposed between the at least one voltage-resistant layer and the gate oxide layer. The metal through holes are uniformly distributed in the interlayer dielectric. A lower end of each of the metal through holes is communicated with a corresponding one of the body regions and corresponding sources. An upper end of each of the metal through holes is communicated with the circuit link layer.

Optionally, more than one voltage-resistant layer is provided.

Optionally, the first columnar region comprises first columns of the second polarity. The second columnar region comprises second columns of the first polarity. The first columns and the second columns are perpendicular to each other.

An upper right corner of the impact-resistant super junction device is defined as an origin. A vertical direction of the impact-resistant super junction device is defined as an X direction. A horizontal direction of the impact-resistant super junction device is defined as a Y direction. The first columns of the second polarity extending in the Y direction and disposed along the Y direction are alternately disposed with the first columns of the second polarity extending in the X direction. The first columns of the second polarity disposed on the X direction and extending in the Y direction are alternately disposed with the first columns of the second polarity extending in the X direction.

An interval between each two adjacent first columns of the second polarity extending in the X direction and disposed along the Y direction is a first interval of the second polarity. An interval between each two adjacent first columns of the second polarity extending in the Y direction and disposed along the X direction is a second interval of the second polarity.

An interval between any one of the first columns of the second polarity extending in the X direction and disposed along the X direction and an adjacent second polar column extending in the Y direction is defined as a third interval of the second polarity. An interval between any one of the first columns of the second polarity extending in the Y direction and disposed along the X direction and an adjacent second polar column extending in the X direction is defined as the third interval of the second polarity.

An interval between any one of the first columns of the second polarity extending in the Y direction and disposed along the Y direction and an adjacent second polar column extending in the X direction is defined as a fourth interval of the second polarity. An interval between any one of the first columns of the second polarity extending in the X direction and disposed along the Y direction and an adjacent second polar column extending in the Y direction is defined as the fourth interval of the second polarity.

When each first interval of the second polarity is equal to each second interval of the second polarity, and each third interval of the second polarity is equal to each fourth interval of the second polarity, the impact-resistant super junction device is in a two-dimensional charge balance state. When each first interval of the second polarity is not equal to each second interval of the second polarity, and each third interval of the second polarity is not equal to each fourth interval of the second polarity, the impact-resistant super junction device is in a first polarity charge surplus working state or a second polarity charge surplus working state.

A second purpose of the present disclosure is to provide a preparing method of an impact-resistant super junction device. The preparing method comprises:
a step A: preparing epitaxial layers;
a step B: preparing at least one voltage-resistant layer;
a step C: preparing a front vertical double-diffused metal-oxide semiconductor (VDMOS) structure; and
a step D: preparing a circuit link layer and at least one passivation layer.

Optionally, the at least one voltage-resistant layer comprises a first columnar region and a second columnar region. The second columnar region is of a first polarity, and the first columnar region is of a second polarity. The first columnar region comprises first columns of the second polarity. The second columnar region comprises second columns of the first polarity.

An upper right corner of the impact-resistant super junction device is defined as an origin. A vertical direction of the impact-resistant super junction device is defined as an X direction. A horizontal direction of the impact-resistant super junction device is defined as a Y direction. The first columns of the second polarity extending in the Y direction and disposed along the Y direction are alternately disposed with the first columns of the second polarity extending in the X direction. The first columns of the second polarity disposed on the X direction and extending in the Y direction are alternately disposed with the first columns of the second polarity extending in the X direction.

Optionally, the step A comprises:
a step S1: growing a first epitaxial layer on a silicon substrate by chemical vapor deposition; and
a step S2: growing a second epitaxial layer on the first epitaxial layer through a high-concentration epitaxial process or performing ion implantation on the first epitaxial layer to obtain the second epitaxial layer.

The first epitaxial layer is configured as a buffer layer of the impact-resistant super-junction device.

Optionally, when only one voltage-resistant layer is provided, the step B comprises:
a step S3: continuing to grow the epitaxial layers by chemical vapor deposition ;
a step S4: growing a hard film by chemical vapor deposition, spin-coating first photoresist on the hard film, exposing the first photoresist through a photoetching machine, defining a first pattern on the photoresist through a first mask, and defining the first pattern of the first photoresist on the hard film by etching;
a step S5: preparing trenches by etching, and then removing the hard film; and
a step S6: growing a reverse conductive layer by the chemical vapor deposition, filling the trenches to obtain the one voltage-resistant layer; performing high-temperature annealing, repairing lattice damage, and activating implanted impurities.

Optionally, when more than one voltage-resistant layer is provided, the step B comprises:
a step S7: continuing to grow the epitaxial layers by chemical vapor deposition, performing ion implantation on the epitaxial layers, spin-coating second photoresist on the, epitaxial layers; defining a second pattern on the second photoresist through a second mask, and performing the ion implantation to obtain reverse doped regions;
a step S8: repeating the step S7 to obtain the more than one voltage-resistant layer of the impact-resistant super junction device; and
a step S9: performing high-temperature annealing, repairing lattice damage, and activating implanted impurities.

Optionally, the step C comprises
a step S10: growing a gate oxide layer and a polysilicon, and etching the gate oxide layer and the polysilicon;
a step S11: performing ion implantation to form body regions and sources; and
a step S 12: performing ion implantation to form ohmic contact regions.

Optionally, the step D comprises:
a step S13: depositing an interlayer dielectric;
a step S14: defining regions of metal through holes by post-exposure etching, depositing the metal through holes by sputtering; depositing a metal layer, spinning third photoresist on the metal layer, exposing and etching the third photoresist to obtain the circuit link layer; and
a step S15: depositing the at least one passivation layer, and exposing a pad region by a photolithography process and an etching process.

The third photoresist is etched by dry etching, wet etching, or a combination thereof.

In the present disclosure, the second columns of the first polarity are N-typed doped columns or P-type doped columns, and a polarity of the first columns of the second polarity is opposite to a polarity of the second columns of the first polarity. The epitaxial layers are N-type epitaxial layers. To sum up, compared with the prior art, in the present disclosure, there is a local electric field extreme value between the P-type columns and the epitaxial layers, which reduces a current value of the epitaxial layers participating in a voltage division after a local avalanche occurs in the impact-resistant super junction device, thereby changing avalanche points of the impact-resistant super junction device and improving an avalanche current withstand capability of the impact-resistant super junction device.

In the present disclosure, the first columns are N-type columns or P-type columns, and the second columns are P-type columns or N-type columns accordingly disposed, which reduces injection efficiency of P-type carriers, thereby reducing a reverse overshoot current and reverse recovery time of the impact-resistant super junction device in a reverse recovery mode.

The impact-resistant super junction device realizes overall voltage resistance of a chip through repeated structures (e.g. the first columns and the second columns) and a terminal structure disposed on an outer periphery of the impact-resistant super junction device.

The repeated structures of the impact-resistant super junction device are disposed in the voltage-resistant layer. A potential difference of the repeated structures and the electric field extreme value generated by the potential difference are exist in the voltage-resistant layer. Therefore, impact resistance of the cell structure is only affected by shapes of the second columns of the first polarity and the first columns of the second polarity and a concentration distribution thereof.

A potential difference endured by the terminal structure of the impact-resistant super junction device not only exists in the voltage-resistant layer but also on a surface of the chip. Therefore, the impact resistance of the impact-resistant super junction device is not only related to the second columns of the first polarity and the first columns of the second polarity, but also related to the potential difference on a surface of the terminal structure and an electric field distribution thereof. By flexibly adjusting a layout of the impact-resistant super junction device, the present disclosure is allowed to enable the avalanches to occur at different locations of the impact-resistant super junction device, adjust the electric field peak value to improve the avalanche current tolerance, and provide a discharge channel, which greatly enhances the impact resistance of impact-resistant super junction device.

### BRIEF DESCRIPTION OF DRAWINGS

Other features, objects and advantages of the present disclosure becomes more apparent by reading the detailed description of the non-limiting embodiments with reference to the following drawings:
FIG. 1 is a schematic diagram of an impact-resistant super junction device after steps S 1-S2 are performed in Embodiments 1-6 and 7- 8 of the present disclosure.
FIG. 2 is a schematic diagram of the impact-resistant super junction device after a step S3 is performed in Embodiments 1-6 and 7- 8 of the present disclosure.
FIG. 3 is a schematic layout diagram of the voltage-resistant layer of the impact-resistant super junction device in Embodiment 1 and Embodiment 7.
FIG. 4 is a schematic layout diagram of the voltage-resistant layer of the impact-resistant super junction device in Embodiment 2 and Embodiment 7.
FIG. 5 is a schematic layout diagram of the voltage-resistant layer of the impact-resistant super junction device in Embodiment 3 and Embodiment 7.
FIG. 6 is a schematic layout diagram of the voltage-resistant layer of the impact-resistant super junction device in Embodiment 4 and Embodiment 7.
FIG. 7 is a schematic layout diagram of the voltage-resistant layer of the impact-resistant super junction device in Embodiment 5 and Embodiment 7.
FIG. 8 is a schematic diagram of the impact-resistant super junction device after a step S5 is performed in Embodiments 1-6 of the present disclosure.
FIG. 9 is a schematic diagram of the impact-resistant super junction device after a step S6 is performed in Embodiments 1-6 of the present disclosure.
FIG. 10 is a schematic diagram of the impact-resistant super junction device after a step S 10 is performed in Embodiments 1-6 of the present disclosure.
FIG. 11 is a schematic diagram of the impact-resistant super junction device after a step S 11 is performed in Embodiments 1-6 of the present disclosure.
FIG. 12 is a schematic diagram of the impact-resistant super junction device after a step S13 is performed in Embodiments 1-6 of the present disclosure.
FIG. 13 is a schematic diagram of the impact-resistant super junction device after a step S 14 is performed in Embodiments 1-6 of the present disclosure.
FIG. 14 is a schematic diagram of the impact-resistant super junction device after a step S15 is performed in Embodiments 1-6 of the present disclosure.
FIG. 15 is a schematic diagram of the impact-resistant super junction device after a step S7 is performed in Embodiments 7-8 of the present disclosure.
FIG. 16 is a schematic diagram of the impact-resistant super junction device after a step S8 is performed in Embodiments 7-8 of the present disclosure.
FIG. 17 is a schematic diagram of the impact-resistant super junction device after a step S 10 is performed in Embodiments 7-8 of the present disclosure.
FIG. 18 is a schematic diagram of the impact-resistant super junction device after the step S11 is performed in Embodiments 7-8 of the present disclosure.
FIG. 19 is a schematic diagram of the impact-resistant super junction device after the step S13 is performed in Embodiments 7-8 of the present disclosure.
FIG. 20 is a schematic diagram of the impact-resistant super junction device after the step S14 is performed in Embodiments 7-8 of the present disclosure.
FIG. 21 is a schematic diagram of the impact-resistant super junction device after the step S15 is performed in Embodiments 7-8 of the present disclosure.

In the drawings:
1-silicon substrate; 2-first epitaxial layer; 3-second epitaxial layer; 4-second columnar region; 5-first columnar region; 5a- third epitaxial layer; 6-gate oxide layer; 7-gate; 8-body region; 9-source; 10-interlayer dielectric; 11-metal through hole; 12-circuit link layer; 13-at least one passivation layer.

### DETAILED DESCRIPTION

The following embodiments will help those skilled in the art to further understand the present disclosure, but do not limit the present disclosure in any form. Those skilled in the art can make changes and improvements without departing from the concept of the present disclosure, all of which should fall within the protection scope of the present disclosure. The endpoints and any values of ranges disclosed herein are not limited to the precise range or value, which should be understood to comprise values close to the ranges or values. For a numerical range, one or more new numerical ranges may be obtained by combining endpoint values of various ranges, endpoint values of various ranges, separate point values, and separate point values, which should be considered as specifically disclosed by the present disclosure. The present disclosure is described in detail below with reference to specific embodiments.

### Embodiment 1

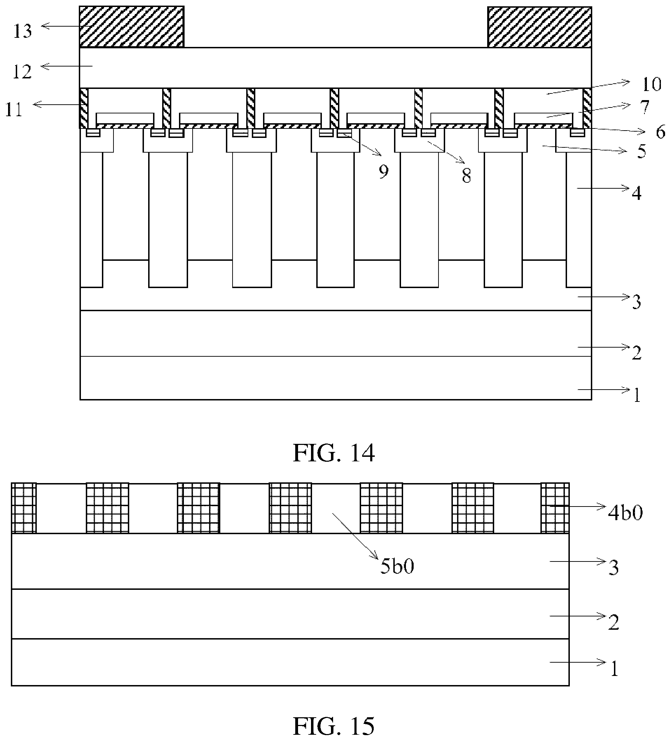

As shown in FIG. 14, the present disclosure provides an impact-resistant super junction device. The impact-resistant super junction device comprises a silicon substrate 1, a first epitaxial layer 2, a second epitaxial layer 3, at least one voltage-resistant layer, a gate oxide layer 6, gates 7, an interlayer dielectric 10, metal through holes 11, a circuit link layer 12, and at least one passivation layer 13.

The silicon substrate 1, the first epitaxial layer 2, the second epitaxial layer 3, the at least one voltage-resistant layer, the gate oxide layer 6, the gates 7, the interlayer dielectric 10, the metal through holes 11, the circuit link layer 12, and the at least one passivation layer 13 are sequentially disposed from bottom to top. The at least one voltage-resistant layer comprises a first columnar region 5 and a second columnar region 5. The second columnar region 4 is of a first polarity, and the first columnar region is of a second polarity. The first polarity is opposite to the second polarity. Body regions 8 and sources 9 are disposed between the at least one voltage-resistant layer and the gate oxide layer 6. The metal through holes 11 are uniformly distributed in the interlayer dielectric 10. A lower end of each of the metal through holes 11 is communicated with a corresponding one of the body regions 8 and corresponding sources 9. An upper end of each of the metal through holes is communicated with the circuit link layer 12.

A resistivity of the second epitaxial layer 3 of the first polarity is less than a resistivity of the first epitaxial layer 2 of the second polarity. The first polarity is N-type doping or P-type doping, and the second polarity is opposite to the first polarity.

The first columnar region 5 comprises first columns of the second polarity. The second columnar region 4 comprises second columns of the first polarity.

An upper right corner of the impact-resistant super junction device is defined as an origin. A vertical direction of the impact-resistant super junction device is defined as an X direction. A horizontal direction of the impact-resistant super junction device is defined as a Y direction. The first columns of the second polarity extending in the Y direction and disposed along the Y direction are alternately disposed with the first columns of the second polarity extending in the X direction. The first columns of the second polarity disposed on the X direction and extending in the Y direction are alternately disposed with the first columns of the second polarity extending in the X direction.

An interval between each two adjacent first columns of the second polarity extending in the X direction and disposed along the Y direction is a first interval of the second polarity. An interval between each two adjacent first columns of the second polarity extending in the Y direction and disposed along the X direction is a second interval of the second polarity. Namely, first intervals and second intervals are defined. The first intervals comprise dx(n+i), and the second intervals comprise dy(n+i).

An interval between any one of the first columns of the second polarity extending in the X direction and disposed along the X direction and an adjacent second polar column extending in the Y direction is defined as a third interval of the second polarity. An interval between any one of the first columns of the second polarity extending in the Y direction and disposed along the X direction and an adjacent second polar column extending in the X direction is defined as the third interval of the second polarity. Namely, third intervals are defined. The third intervals comprise x(n+i)a and x(n+i)b.

An interval between any one of the first columns of the second polarity extending in the Y direction and disposed along the Y direction and an adjacent second polar column extending in the X direction is defined as a fourth interval of the second polarity. An interval between any one of the first columns of the second polarity extending in the X direction and disposed along the Y direction and an adjacent second polar column extending in the Y direction is defined as the fourth interval of the second polarity. Namely, fourth intervals are defined. The fourth intervals comprise y(n+i)a and y(n+i)b. n and i are non-negative integers.

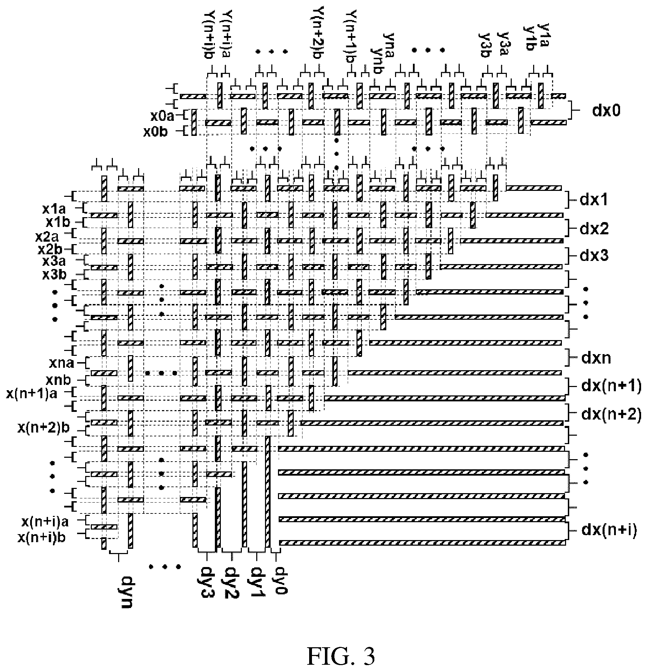

Specifically in the embodiment, as shown in FIG. 3, the first intervals specifically comprise dx0, dx1, dx2, dx3...dxn, 1x(n+1), dx(n+2)...dx(n +i). The second intervals specifically comprise dy0, dy1, dy2, dy3...dyn. The third intervals specifically comprise x1a, x1b, x2a, x2b, x3a, x3b...xna, xnb, x(n+1)a, x(n+1)b, x(n+2)a, x(n+2b)...x(n+i)a, x(n+i)b. The fourth intervals specifically comprise y1a, y1b, y2a, y2b, y3a, y3b...yna, ynb, y(n+1)a, y(n+1)b, y(n+2)a, y(n+2)b...y(n+i)a, y(n+i)b. n is not less than 1, and i is not less than 1.

When each first interval of the second polarity is equal to each second interval of the second polarity, and each third interval of the second polarity is equal to each fourth interval of the second polarity, the impact-resistant super junction device is in a two-dimensional charge balance state. When each first interval of the second polarity is not equal to each second interval of the second polarity, and each third interval of the second polarity is not equal to each fourth interval of the second polarity, the impact-resistant super junction device is in a first polarity charge surplus working state or a second polarity charge surplus working state.

### Embodiment 2

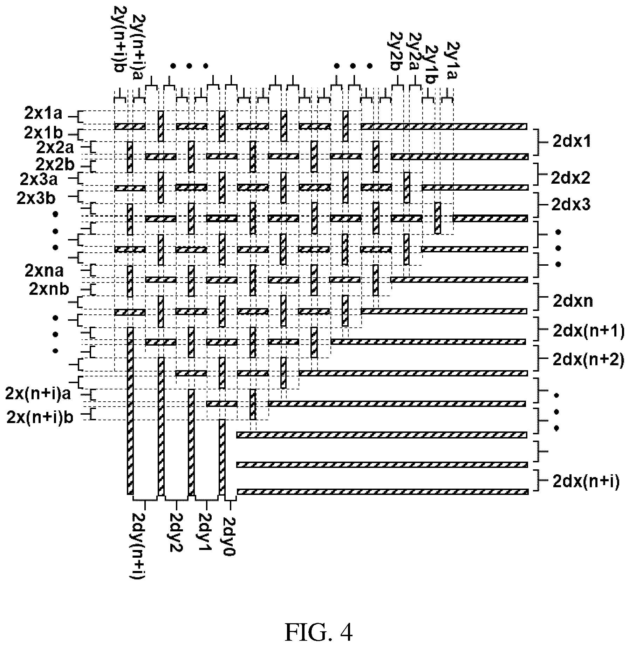

The embodiment disclose an impact-resistant super junction device as shown in FIG. 4. The difference from Embodiment 1 is that the first intervals specifically comprise 2dx1, 2dx2, 2dx3...2dxn, 2dx(n+1), 2dx(n+2)...2dx(n+i). The second interval specifically comprise 2dy0, 2dy1, 2dy2...2dy(n+i). The third intervals specifically comprise 2xla, 2xlb, 2x2a, 2x2b, 2x3a, 2x3b...2xna, 2xnb...2x(n+i)a, and 2x(n+i)b. The fourth intervals specifically comprise 2yla, 2ylb, 2y2a, 2y2b...2yna, 2ynb, 2y(n+1)a, 2y(n+1)b...2y(n+i)a, and 2y(n+ i)b. n is not less than 1 and i not less than 1.

### Embodiment 3

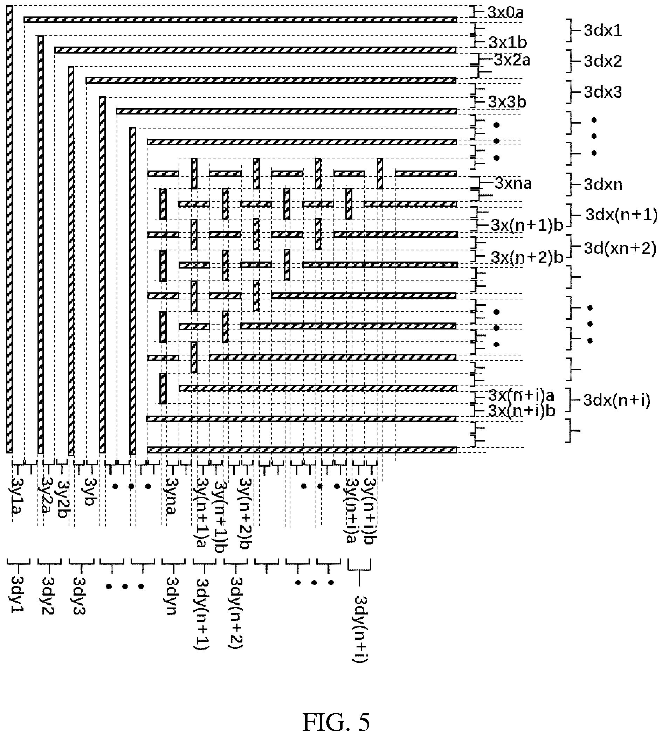

The embodiment disclose an impact-resistant super junction device as shown in FIG. 5. The difference from Embodiment 1 is that the first intervals specifically comprise 3dx1, 3dx2, 3dx3...3dxn, 3dx(n+1), 3dx(n+2)...3dx(n+i). The second intervals specifically comprise 3dy1, 3dy2, 3dy3...3dy(n+1), 3dy(n+2)...3dy(n+i). The third intervals specifically comprise 3x0a, 3xla, 3xlb, 3x2a, 3x2b, 3x3a, 3x3b...3xna, 3xnb, 3x(n+1)a, 3x(n+1)b, 3x(n+2) a, 3x(n+2)b...3x(n+i)a, 3x(n+i)b. The fourth intervals specifically comprise 3yla, 3ylb, 3y2a, 3y2b...3yna, 3ynb, 3y(n+1)a, 3y(n+1)b, 3y(n+2)a, 3y(n+ 2)b...3y(n+i)a, 3y(n+i)b, n is not less than 1 and i not less than 1.

### Embodiment 4

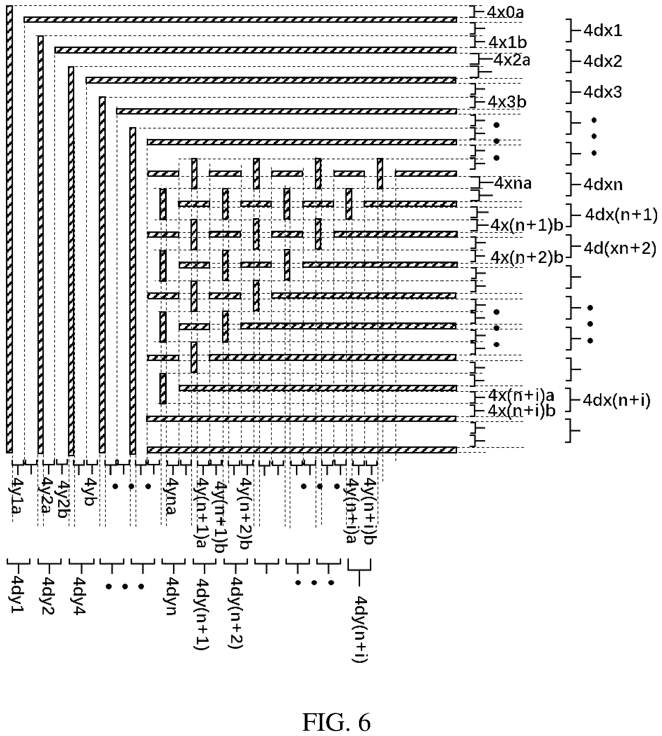

The embodiment disclose an impact-resistant super junction device as shown in FIG. 6. The difference from Embodiment 1 is that the first intervals specifically comprise 4dx1, 4dx2, 4dx3...4dxn, 4dx(n+1), 4dx(n+2)...4dx(n+i). The second intervals specifically comprise 4dy1, 4dy2, 4dy3...4dy(n+1), 4dy(n+2)...4dy(n+i). The third intervals specifically comprise 4xla, 4xlb, 4x2a, 4x2b, 4x3a, 4x3b...4xna, 4xnb, 4x(n+1)a, 4x(n+1)b, 4x(n+2)a, 4x(n+2)b...4x(n+i)a, and 4x(n+i)b. The fourth type of intervals of the second polarity specifically comprise 4yla, 4ylb, 4y2a, 4y2b...4yna, 4ynb, 4y(n+1)a, 4y(n+1)b, 4y(n+2)a, 4y(n+ 2)b...4y(n+i)a, and 4y(n+i)b, n is not less than 1 and i not less than 1.

### Embodiment 5

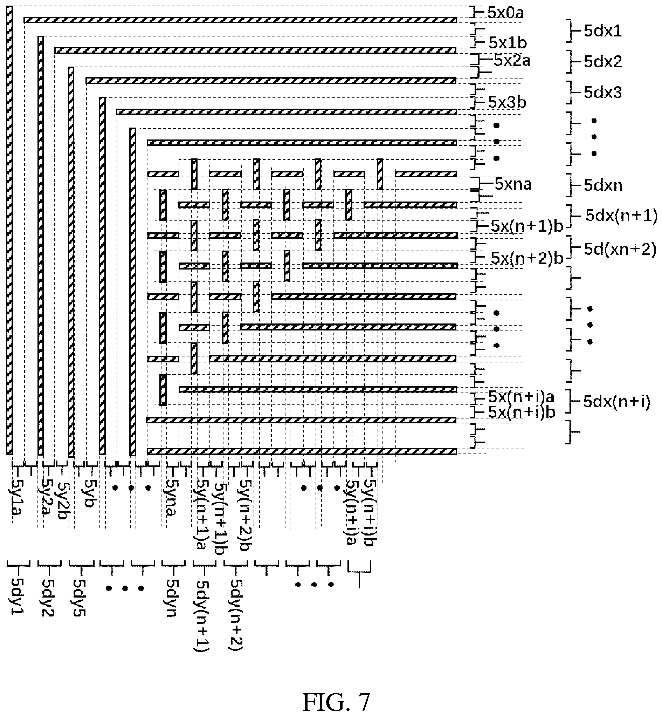

The embodiment disclose an impact-resistant super junction device as shown in FIG. 7. The difference from Embodiment 1 is that the first intervals specifically comprise 5dx1, 5dx2, 5dx3...5dxn, 5dx(n+1), 5dx(n+2)...5dx(n+i). The second intervals specifically comprise 5dy1, 5dy2, 5dy3...5dy(n+1), 5dy(n+2)...5dy(n+i). The third intervals specifically comprise 5xla, 5xlb, 5x2a, 5x2b, 5x3a, 5x3b...5xna, 5xnb, 5x(n+1)a, 5x(n+1)b, 5x(n+2)a, 5x(n+2)b...5x(n+i)a, and 5x(n+i)b. The fourth type of intervals of the second polarity specifically comprise 5yla, 5ylb, 5y2a, 5y2b...5yna, 5ynb, 5y(n+1)a, 5y(n+1)b, 5y(n+2)a, 5y(n+ 2)b...5y(n+i)a, and 5y(n+i)b, n is not less than 1 and i not less than 1.

### Embodiment 6

The embodiment disclose a preparing method of the impact-resistant super junction device in any one of the Embodiments 1-5. The preparing method comprises steps A-C. The step A comprises preparing epitaxial layers. The step B comprises preparing the at least one voltage-resistant layer. The step C comprises preparing a front vertical double-diffused metal-oxide semiconductor (VDMOS) structure. The step D comprises preparing the circuit link layer and the at least one passivation layer.

In one embodiment, the step A comprises steps S 1-S2.

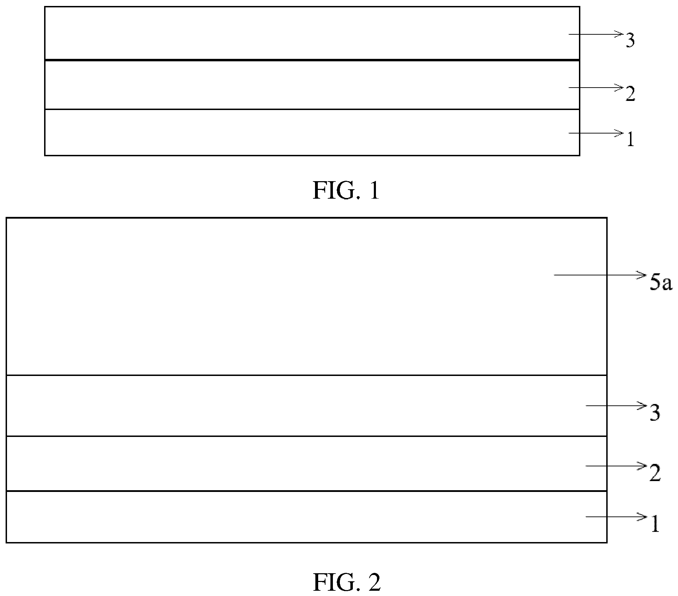

As shown in FIG. 1, the step S1 comprises growing the first epitaxial layer 2 on the silicon substrate 1 by chemical vapor deposition. The first epitaxial layer 2 is of the second polarity.

As shown in FIG. 1, the step S2 comprises growing the second epitaxial layer 3 on the first epitaxial layer 1 through a high-concentration epitaxial process or performing ion implantation on the first epitaxial layer to obtain the second epitaxial layer 2. Of course, the second epitaxial layer 3 may also be obtained by a low-concentration epitaxial process or a low-concentration epitaxial process, which is not limited thereto. The resistivity of the second epitaxial layer 3 is less than the resistivity of the first epitaxial layer 2. The first epitaxial layer 2 is configured as a buffer layer of the impact-resistant super-junction device.

In one embodiment, when only one voltage-resistant layer is provided, the step B comprises steps S3-S6.

As shown in FIG. 2, the step S3 comprises continuing to grow a third epitaxial layer 5a by chemical vapor deposition. The third epitaxial layer 5a is then configured as the second polarity columnar region 5.

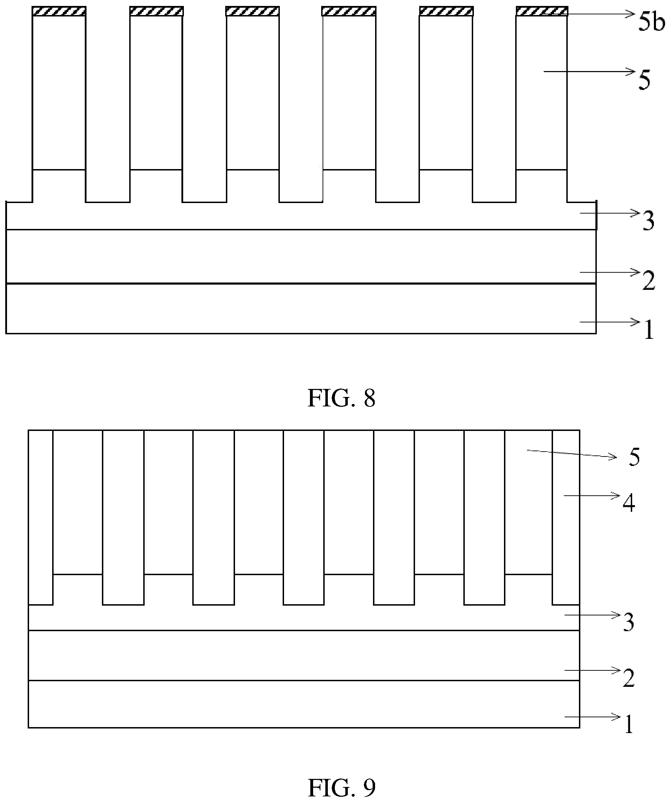

As shown in FIG. 8, the step S4 comprises growing a hard film 5b by the chemical vapor deposition or hot oxygen, spin-coating first photoresist on the hard film 5b, exposing the first photoresist through a photoetching machine, defining a first pattern on the photoresist through a first mask, and defining the first pattern of the first photoresist on the hard film 5b by etching. The hard film is made from silicon oxide, silicon nitride or other etching-resistant films, etc. The first pattern on the first mask may adopt a layout shown in any one of FIGS. 1-7 and etc.

As shown in FIG. 8, the step S5 comprises preparing trenches by etching, and then removing the hard film 5b to obtain the second polarity columnar region 5.

As shown in FIG. 9, the step S6 comprises growing a reverse conductive layer by the chemical vapor deposition, filling the trenches to obtain the one voltage-resistant layer, and performing high-temperature annealing, repairing lattice damage, and activating implanted impurities to obtain the first polarity columnar region 4. Therefore, the one voltage-resistant layer of the impact-resistant super junction device is obtained.

In one embodiment, the step C of preparing the VDMOS structure comprises steps S10-S12.

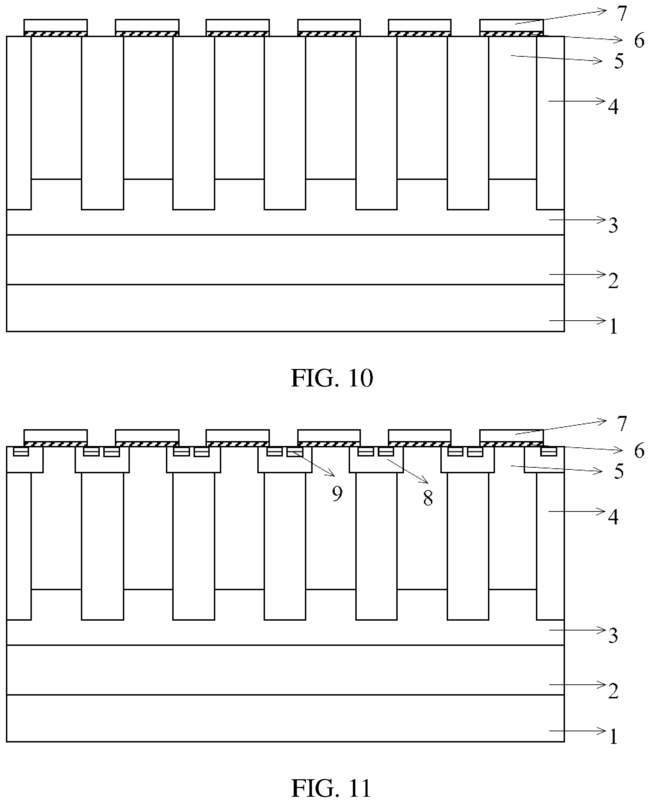

As shown in FIG. 10, the step S10 comprises growing a gate oxide layer and a polysilicon through a high temperature oxidation process, and etching the gate oxide layer and the polysilicon by defining a third pattern through coating fourth photoresist, exposing the fourth photoresist. Therefore, the VDMOS structure including the gate oxide layer 6 and the gates 7 is obtained.

As shown in FIG. 11, the step S11 comprises obtaining the body regions 8 by performing the ion implantation and high-temperature annealing in sequence, and after completing a preparation of the body regions 8, spin-coating fifth photoresist on the body regions 8, exposing the body regions 8 through the photoetching machine, performing the ion implantation, removing the fifth photoresist, performing high-temperature annealing to obtain the sources 9.

The step S12 comprises after a fourth pattern is define by exposing a sixth photoresist through the photoetching machine, performing ion implantation to form ohmic contact regions. The ohmic contact regions comprise the gates, the body regions, and the sources 9.

In one embodiment, the step D of preparing the circuit link layer and the at least one passivation layer comprises steps S13-S15.

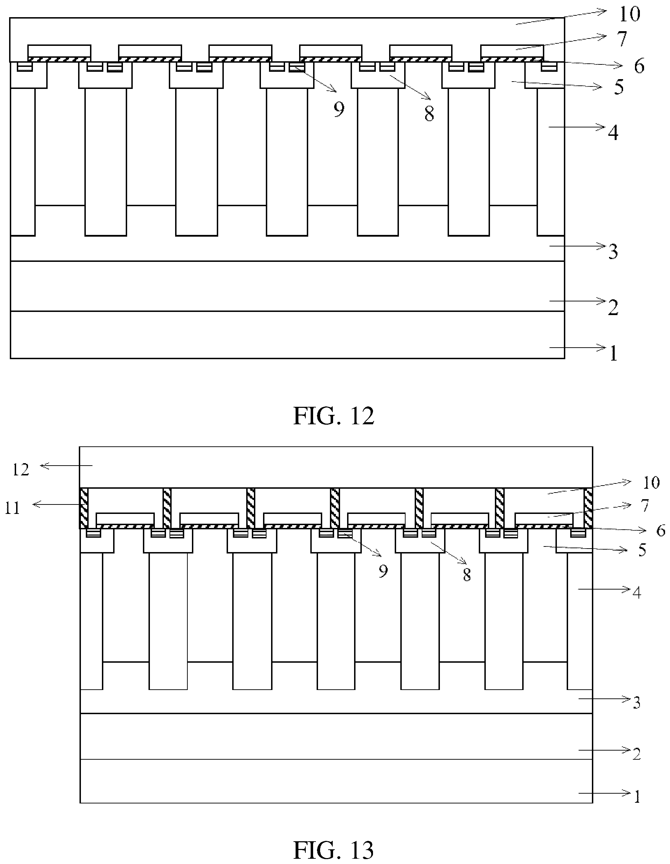

As shown in FIG. 12, the step S13 comprises depositing the interlayer dielectric 10 through the chemical vapor deposition. As shown in FIG. 13, the step S14 comprises defining regions of metal through holes 11 by post-exposure etching, depositing the metal through holes by sputtering, depositing a metal layer, spinning third photoresist on the metal layer, and exposing and etching the third photoresist to obtain the circuit link layer 12. The third photoresist is etched by dry etching, wet etching, or a combination thereof. As shown in FIG. 14, the step S15 comprises depositing the at least one passivation layer 13, and exposing a pad region by a photolithography process and an etching process. The pad region is a metal region for welding. Therefore, as shown in FIG. 14, the impact-resistant super junction device disclosed in Embodiments 1-5 is obtained.

### Embodiment 7

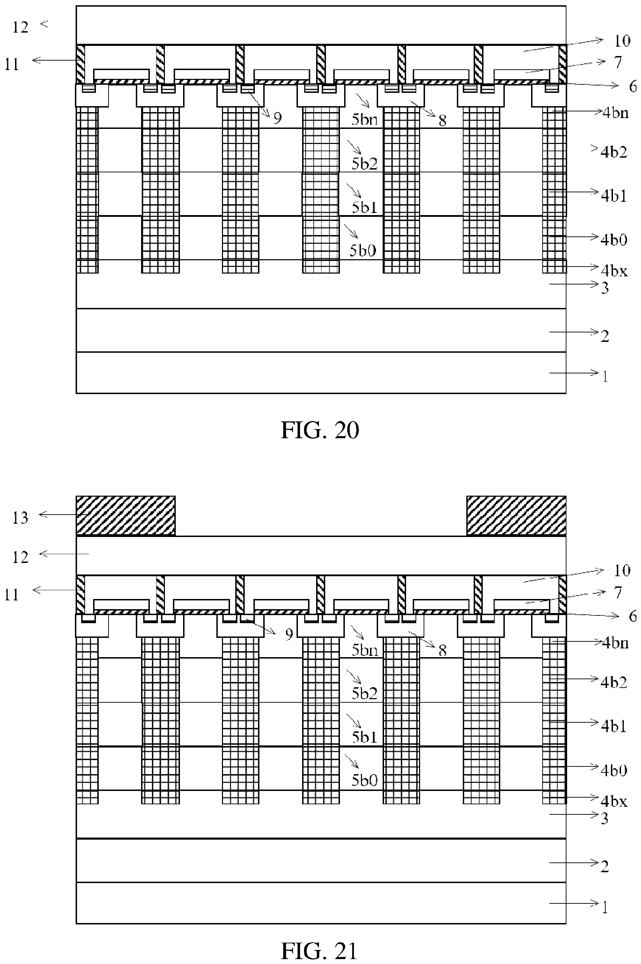

The embodiment discloses the impact-resistant super junction device as shown in FIG. 21. A difference from Embodiment 1 is that more than one voltage-resistant layer is provided.

### Embodiment 8

The embodiment disclose a preparing method of the impact-resistant super junction device in the Embodiment 7. The preparing method comprises steps A-C. The step A comprises preparing epitaxial layers. The step B comprises preparing the at least one voltage-resistant layer. The step C comprises preparing a front vertical double-diffused metal-oxide semiconductor (VDMOS) structure. The step D comprises preparing the circuit link layer and the at least one passivation layer.

In one embodiment, the step A comprises steps S 1-S2.

As shown in FIG. 1, the step S1 comprises growing the first epitaxial layer 2 on the silicon substrate 1 by chemical vapor deposition. The first epitaxial layer 2 is of the second polarity.

As shown in FIG. 1, the step S2 comprises growing the second epitaxial layer 3 on the first epitaxial layer 1 through a high-concentration epitaxial process or performing ion implantation on the first epitaxial layer to obtain the second epitaxial layer 2. Of course, the second epitaxial layer 3 may also be obtained by a low-concentration epitaxial process or a low-concentration epitaxial process, which is not limited thereto. The resistivity of the second epitaxial layer 3 is less than the resistivity of the first epitaxial layer 2. The first epitaxial layer 2 is configured as a buffer layer of the impact-resistant super-junction device.

In the embodiment, when the more than one voltage-resistant layer is provided, the step B of preparing the at least one voltage-resistant layer comprises steps S7-S9.

As shown in FIG. 15, the step S7 comprises continuing to grow the epitaxial layers by chemical vapor deposition to obtain first regions 5b0 of the second polarity, performing ion implantation on the epitaxial layers, spin-coating second photoresist on the, epitaxial layers; defining a second pattern on the second photoresist through a second mask, and performing the ion implantation to obtain second regions 4b0 of the first polarity (i.e., reverse doped regions).

The second pattern of the second mask required to form the second regions of the first polarity may adopt the layout shown in any one of FIGS.3-7 and etc.

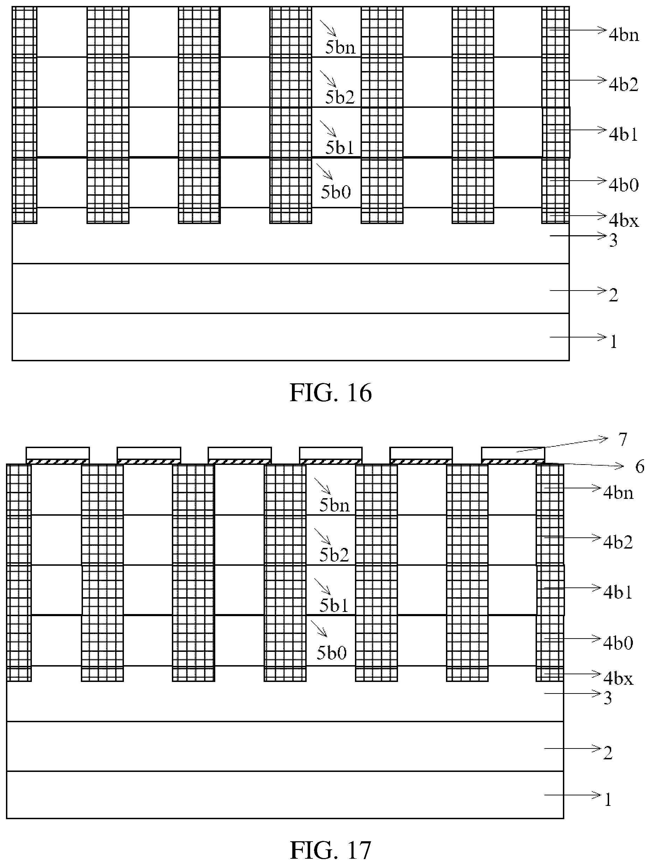

As shown in FIG. 16, the step S8 comprises repeating the step S7 to obtain the second regions 4b1, 4b2, ...4bn, and the first regions 5b1, 5b2, ...5bn, so as to form the more than one voltage-resistant layer of the impact-resistant super junction device. The second regions 4b1, 4b2, and 4b together form the second columnar region 4, and the first regions 5b1, 5b2, and 5bn together form the first columnar region 5.

The step S9 comprises performing high-temperature annealing, repairing lattice damage, and activating implanted impurities to from diffusion regions 4bx of the first polarity. Specifically, the diffusion regions 4bx of the first polarity are formed by an influence of high temperature processes.

In one embodiment, the step C of preparing the VDMOS structure comprises steps S10-S12.

As shown in FIG. 17, the step S10 comprises growing the gate oxide layer 6 and the polysilicon through a high temperature oxidation process, and etching the gate oxide layer and the polysilicon by defining a third pattern through coating fourth photoresist, exposing the fourth photoresist. Therefore, the VDMOS structure including the gate oxide layer 6 and the gates 7 is obtained.

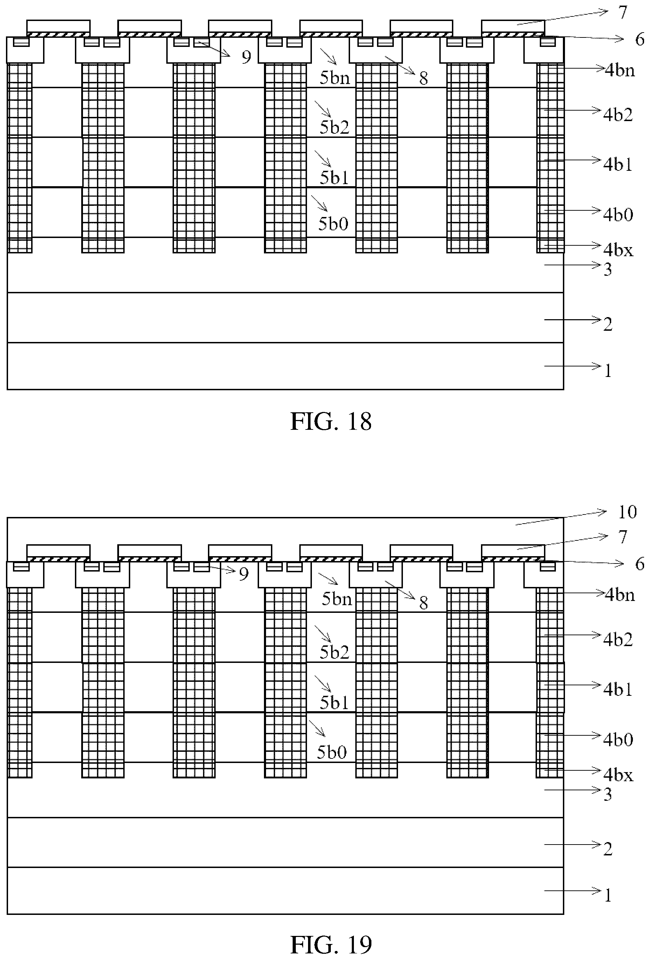

As shown in FIG. 18, the step S11 comprises obtaining the body regions 8 and the sources 9by performing the ion implantation and high-temperature annealing in sequence.

The step S12 comprises after a fourth pattern is define by exposing a sixth photoresist through the photoetching machine, performing ion implantation to form ohmic contact regions. The ohmic contact regions comprise the gates, the body regions, and the sources 9.

In one embodiment, the step D of preparing the circuit link layer and the at least one passivation layer comprises steps S13-S15.

As shown in FIG. 19, the step S13 comprises depositing the interlayer dielectric 10 through the chemical vapor deposition. As shown in FIG. 20, the step S14 comprises defining regions of metal through holes 11 by post-exposure etching, depositing the metal through holes by sputtering, depositing a metal layer, spinning third photoresist on the metal layer, and exposing and etching the third photoresist to obtain the circuit link layer 12. The third photoresist is etched by dry etching, wet etching, or a combination thereof. As shown in FIG. 21, the step S15 comprises depositing the at least one passivation layer 13, and exposing a pad region by a photolithography process and an etching process. The pad region is a metal region for welding. Therefore, as shown in FIG. 21, the impact-resistant super junction device disclosed in Embodiment 7 is obtained.

Specific embodiments of the present disclosure are described above. It should be understood that the present disclosure is not limited to the specific embodiments described above, and those skilled in the art can make various changes or modifications within the scope of the claims, which does not affect the essential content of the present disclosure. In the case of no conflict, the embodiments of the present disclosure and the features in the embodiments may be combined with each other.

## Claims

1. An impact-resistant super junction device, comprising:
a silicon substrate,
a first epitaxial layer,
a second epitaxial layer,
at least one voltage-resistant layer,
a gate oxide layer,
gates,
an interlayer dielectric,
metal through holes,
a circuit link layer, and
at least one passivation layer;
wherein the silicon substrate, the first epitaxial layer, the second epitaxial layer, the at least one voltage-resistant layer, the gate oxide layer, the gates, the interlayer dielectric, the metal through holes, the circuit link layer, and the at least one passivation layer are sequentially disposed from bottom to top; the at least one voltage-resistant layer comprises a first columnar region and a second columnar region; the second columnar region is of a first polarity; the first columnar region is of a second polarity; the first polarity is opposite to the second polarity; body regions and sources are disposed between the at least one voltage-resistant layer and the gate oxide layer; the metal through holes are uniformly distributed in the interlayer dielectric; a lower end of each of the metal through holes is communicated with a corresponding one of the body regions and corresponding sources; an upper end of each of the metal through holes is communicated with the circuit link layer.

2. The impact-resistant super junction device according to claim 1, wherein more than one voltage-resistant layer is provided.

3. The impact-resistant super junction device according to claim 1, wherein the first columnar region comprises first columns of the second polarity; the second columnar region comprises second columns of the first polarity;
an upper right corner of the impact-resistant super junction device is defined as an origin; a vertical direction of the impact-resistant super junction device is defined as an X direction; a horizontal direction of the impact-resistant super junction device is defined as a Y direction; the first columns of the second polarity extending in the Y direction and disposed along the Y direction are alternately disposed with the first columns of the second polarity extending in the X direction; the first columns of the second polarity disposed on the X direction and extending in the Y direction are alternately disposed with the first columns of the second polarity extending in the X direction;
wherein an interval between each two adjacent first columns of the second polarity extending in the X direction and disposed along the Y direction is a first interval of the second polarity; an interval between each two adjacent first columns of the second polarity extending in the Y direction and disposed along the X direction is a second interval of the second polarity;
wherein an interval between any one of the first columns of the second polarity extending in the X direction and disposed along the X direction and an adjacent second polar column extending in the Y direction is defined as a third interval of the second polarity; an interval between any one of the first columns of the second polarity extending in the Y direction and disposed along the X direction and an adjacent second polar column extending in the X direction is defined as the third interval of the second polarity;
wherein an interval between any one of the first columns of the second polarity extending in the Y direction and disposed along the Y direction and an adjacent second polar column extending in the X direction is defined as a fourth interval of the second polarity; an interval between any one of the first columns of the second polarity extending in the X direction and disposed along the Y direction and an adjacent second polar column extending in the Y direction is defined as the fourth interval of the second polarity;
when each first interval of the second polarity is equal to each second interval of the second polarity, and each third interval of the second polarity is equal to each fourth interval of the second polarity, the impact-resistant super junction device is in a two-dimensional charge balance state; when each first interval of the second polarity is not equal to each second interval of the second polarity, and each third interval of the second polarity is not equal to each fourth interval of the second polarity, the impact-resistant super junction device is in a first polarity charge surplus working state or a second polarity charge surplus working state.

4. A preparing method of an impact-resistant super junction device, comprising:
a step A: preparing epitaxial layers;
a step B: preparing at least one voltage-resistant layer;
a step C: preparing a front vertical double-diffused metal-oxide semiconductor (VDMOS) structure; and
a step D: preparing a circuit link layer and at least one passivation layer.

5. The preparing method according to claim 4, wherein the at least one voltage-resistant layer comprises a first columnar region and a second columnar region; the second columnar region is of a first polarity, and the first columnar region is of a second polarity; the first polarity is opposite to the second polarity; the first columnar region comprises first columns of the second polarity; the second columnar region comprises second columns of the first polarity;
wherein an upper right corner of the impact-resistant super junction device is defined as an origin, a vertical direction of the impact-resistant super junction device is defined as an X direction; a horizontal direction of the impact-resistant super junction device is defined as a Y direction; the first columns of the second polarity extending in the Y direction and disposed along the Y direction are alternately disposed with the first columns of the second polarity extending in the X direction; the first columns of the second polarity disposed on the X direction and extending in the Y direction are alternately disposed with the first columns of the second polarity extending in the X direction.

6. The preparing method according to claim 4, wherein the step A comprises:
a step S1: growing a first epitaxial layer on a silicon substrate by chemical vapor deposition; and
a step S2: growing a second epitaxial layer on the first epitaxial layer through a high-concentration epitaxial process or performing ion implantation on the first epitaxial layer to obtain the second epitaxial layer;
wherein the first epitaxial layer is configured as a buffer layer of the impact-resistant super-junction device.

7. The preparing method according to claim 4, wherein when only one voltage-resistant layer is provided, the step B comprises:
a step S3: continuing to grow the epitaxial layers by chemical vapor deposition ;
a step S4: growing a hard film by chemical vapor deposition, spin-coating first photoresist on the hard film, exposing the first photoresist through a photoetching machine, defining a first pattern on the photoresist through a first mask, and defining the first pattern of the first photoresist on the hard film by etching;
a step S5: preparing trenches by etching, and then removing the hard film; and
a step S6: growing a reverse conductive layer by the chemical vapor deposition, filling the trenches to obtain the one voltage-resistant layer; performing high-temperature annealing, repairing lattice damage, and activating implanted impurities.

8. The preparing method according to claim 7, wherein when more than one voltage-resistant layer is provided, the step B comprises:
a step S7: continuing to grow the epitaxial layers by chemical vapor deposition, performing ion implantation on the epitaxial layers, spin-coating second photoresist on the, epitaxial layers; defining a second pattern on the second photoresist through a second mask, and performing the ion implantation to obtain reverse doped regions;
a step S8: repeating the step S7 to obtain the more than one voltage-resistant layer of the impact-resistant super junction device; and
a step S9: performing high-temperature annealing, repairing lattice damage, and activating implanted impurities.

9. The preparing method according to claim 4, wherein the step C comprises
a step S10: growing a gate oxide layer and a polysilicon, and etching the gate oxide layer and the polysilicon;
a step S11: performing ion implantation to form body regions and sources; and
a step S 12: performing ion implantation to form ohmic contact regions.

10. The preparing method according to claim 4, wherein the step D comprises:
a step S13: depositing an interlayer dielectric;
a step S14: defining regions of metal through holes by post-exposure etching, depositing the metal through holes by sputtering; depositing a metal layer, spinning third photoresist on the metal layer, exposing and etching the third photoresist to obtain the circuit link layer; and
a step S15: depositing the at least one passivation layer, and exposing a pad region by a photolithography process and an etching process;
wherein the third photoresist is etched by dry etching, wet etching, or a combination thereof.
